(19) Europäisches Patentamt
European Patent Office
Office européen des brevets

(11) **EP 2 540 661 A1**

(12) **EUROPEAN PATENT APPLICATION**

(43) Date of publication:
**02.01.2013 Bulletin 2013/01**

(51) Int Cl.:
***B81C 99/00*** *(2010.01)*

(21) Application number: **11005191.9**

(22) Date of filing: **27.06.2011**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **ETH Zurich
8092 Zürich (CH)**

(72) Inventors:
• **Galliker, Patrick**
 **4053 Basel (CH)**
• **Schneider, Julian**
 **8005 Zürich (CH)**
• **Poulikakos, Dimos**
 **8702 Zollikon (CH)**
• **Sandoghdar, Vahid**
 **96047 Bamberg (DE)**
• **Eghlidi, Mohammad Hadi**
 **8092 Zürich (CH)**

(54) **Method for nano-dripping 1D, 2D, 3D structures on a substrate**

(57)     A method for the production of nano- or microscaled 1D, 2D and/or 3D depositions from an solution (6), by means of a liquid reservoir (2) for holding the ink with an outer diameter (3,D) of at least 50 nm, is proposed, wherein there is provided an electrode (7,8 or 9) in contact with said ink (6) in said capillary (2), and wherein there is a counter electrode in and/or on and/or below and/or above a substrate (15) onto which the depositions are to be produced, including the steps of:
i) keeping the electrode (7, 8, 9) and the counter electrode (15, 18) on an essentially equal potential;
ii) establishing a potential difference between the electrode (7, 8, 9) and the counter electrode (15, 18) leading to the growth of an ink meniscus (11) at the nozzle (3) and to the ejection of droplets (13) at this meniscus with a homogeneous size smaller than the meniscus size (11) at a homogenous ejection frequency;
keeping the voltage applied while the continuously dried droplets leave behind the dispersed material which leads a structure to emerge with essentially the same diameter as a single droplet,
wherein the distance between the substrate (1) and the nozzle (3) is smaller than or equal to 20 times the meniscus diameter at least at the moment of nano-droplet ejection (12); wherein the conductivity of the ink (6) is high enough to stabilize the liquid meniscus during droplet ejection;

FIG. 20

**Description**

TECHNICAL FIELD

The present invention relates to methods for the production of 1D, 2D and/or 3D depositions from a liquid loaded with nanoparticles or other solid-phase nano-compounds stably dispersed in a solvent, by means of a nozzle-ended container for holding the liquid, wherein there is provided an electrode in contact with said liquid at said nozzle or in said container, and wherein there is a counter electrode in and/or on and/or below and/or above a substrate onto which the depositions are to be produced.

PRIOR ART

The controlled and spatially resolved deposition of pigmented liquids onto surfaces is of interest in a large variety of fields, in particular in the field of printing, the generation of conductor tracks or other functional entities for micro devices (printed electronics), especially for flexible devices and in the field of biological and/or chemical testing and substance/sample handling, for the production of photonic devices like photonic crystals or plasmonic structures, for the creation of microfluidic devices and especially if rapid-prototyping is of concern for the production of any of the mentioned fields. Manufacturing technologies at the nanometer scale can be classified into two groups. On the one hand there are the bottom-up techniques, building larger structures by assembling smaller ones, and on the other hand there are top-down techniques essentially carving out material from a larger volume. The most economically important methodology for the production of nano or micro-structures is photolithography. This technique can achieve features sizes of less than 50 nm, wherein feature size means the lateral dimensions of a built structure. Photolithography is a top-down technique, which allows etching a host of types of structures from a larger entity and therefore is not very efficient in saving material because of the etching removal process and related waste. Furthermore it relies on the coating of extremely expensive materials, e.g. by physical vapor deposition which is a very wasteful technique. Another shortcoming of photolithography is that it is very complicated and expensive, e.g. because of the fact that 3D structures are only possible in a layer by layer fashion of the 2D restricted fabrication steps. Only economies of scale allow the production of affordable products based on photolithography. This implies that rapid-prototyping based on photolithography will remain capital-intensive.

An example of bottom-up production is the self-assembly method which is efficient in the sense that it does not require an external "forced" means of directing it, but only relies on the "natural" guiding hands of the thermodynamic potentials. Parameters of the process can be varied to allow processes to progress that would be forbidden under other conditions.

Still, some processes will never be possible merely by self-assembly. In order to build well-defined and arbitrary structures it is important to control much more parameters than just some boundary conditions. A big advantage of bottom-up processes is material saving. The most efficient way of a bottom-up process results in zero material waste because the whole amount of material used during the process if implemented into the desired structures. In other words, material is only placed where it is actually needed.

While common ink-jet printing by piezo-, acoustic- or themal actuation is another form of bottom-up process which, with the building blocks being controllable droplets rather than molecules, would basically allow for a very flexible production scheme, it only allows for resolutions in the range of O (10) $\mu$m and therefore does not qualify as a nanofabrication tool. Furthermore it does only allow very limited 3D possibilities. Another ink-based production scheme is by direct writing, e.g. of polyelectrolyte inks. One of the main benefits of this method is its vast 3D possibilities. However, the ink designs are highly complex and extremely important for the method to work. Additionally, the feature sizes which are achievable by this method are limited to about 600 nm while the production scheme only hardly allows a large up-scaling.

A very interesting way of on-demand non-contact formation of structures but with the possibility of creating feature sizes below 1 $\mu$m is based on the ejection of material-loaded liquid portions by electrohydrodynamic printing. EP 1477230 discloses an ultrafine fluid jet apparatus comprising a substrate arranged near a distal end of an ultrafine-diameter nozzle to which a solution is supplied, and an optional- waveform voltage is applied to the solution in the nozzle to eject an ultrafine-diameter fluid jet onto a surface of the substrate; wherein an electric field intensity near the distal end of the nozzle according to a diameter reduction of the nozzle is sufficiently larger than an electric field acting between the nozzle and the substrate; and wherein Maxwell stress and an electrowetting effect being utilized, a conductance is decreased by a reduction in the nozzle diameter or the like, and controllability of an ejection rate by a voltage is improved; and wherein landing accuracy is exponentially improved by moderation of evaporation by a charged droplet and acceleration of the droplet by an electric field. All of these methods are developed and used in many applications, but still have their limits regarding the spatial resolution and repeatability, i.e. in particular due to the interaction of highly charged droplets which are close together in the air and deflect each other. These droplets are created from a continuous fluid jet due to instabilities. Also the production of ever smaller deposits is hardly achievable because the continuous accumulation of fluid leads to a spread of printed material on the substrate. Due to the same reason jet-like ejection of nanomaterial loaded liquid to the surface does not allow the local accumulation of nano-material at the place of ejection for the growth of a 3D structure unless the printing process is interrupted allowing the liquid to dry before another portion of liquid is ejected. In both cases the reduction of the period of the intermittent electric field can reduce the size of a printed droplet, but it cannot be reduced to such an amount that only one droplet with the same diameter as of the jet would be ejected. The size of a printed fluid can therefore not be as small as the size of a single droplet. Even if such a procedure would be physically feasible, the time to build a jet, being the time of formation of a jet portion with a length equal to the jet diameter, is based on the liquid viscosity $\mu$ and surface tension $\gamma$ and is described by the following formula:

$$\tau_j = \frac{\eta d}{\gamma} \qquad\qquad (1.1)$$

If a droplet of water with diameter d = 100 nm, equal to the jet diameter, should be ejected, the time of jet build-up would be slightly above 10 ns. Therefore for on-demand printing of a droplet based on pure jetting, an electric device would have to supply electric pulses in the range of O (100) V with a dwell rate well below 10 ns and slight deviation from this value would, due to the continuous fluid jet, already result in much larger liquid volumes being ejected. Such low pulse lengths at the high frequencies are extremely difficult to realize, if at all possible.

The nature of a fluid jet, allowing continuous and high volume flows to a substrate, an advantage for many applications, in this sense is a disadvantage. These are aspects where the present invention proposes novel concepts leading to significant improvements.

US 2006198959 in this field proposes a fluid jet based method of producing a three-dimensional structure containing the steps of: arranging a substrate close to a tip of a needle-shaped fluid-ejection body having a fine diameter supplied with a solution, ejecting a fluid droplet having an ultra-fine diameter toward a surface of the substrate by applying a voltage having a prescribed waveform to the needle-shaped fluid-ejection body, making the droplet fly and land on the substrate, and solidifying the droplet after the fluid droplet is landed on the substrate; further a three-dimensional structure having a fine diameter comprises droplets having an ultra-fine particle diameter, wherein the structure is grown by solidifying the droplets and stacking the solidified droplets. Since for execution of this method a fluid jet device is used and droplets do therefore originate from a jet, the main problems described above persist and structures can therefore only be printed in an interrupting manner wherein the evaporation time of a single droplet can take up to seconds in this embodiment. As a countermeasure the implementation of a heating element in contact with the substrate can increase fluid evaporation and is proposed in order to decrease the interval between successive droplet ejections. Heating sources near the used capillary nozzle will, however, lead to an increase in clogging and do therefore not allow reducing the nozzle-substrate distance below a certain value without experiencing serious clogging problems. This embodiment further shows a relation between printed structure size and voltage that is positive, meaning that higher voltages lead to larger dot diameters. This is in contrast to the well known scaling behavior of the cone-jet mode which states a negative relationship for the jet size. The origin of this positive relationship is most probably connected to larger flow rates experienced if voltage is increased and the connected higher fluid volumes ejected per time period leading to the accumulation of a larger amount of fluid on the substrate, effectively increasing the dot diameter. A decrease of dot size is mainly targeted by increasing the evaporation during flight, even a complete evaporation of the fluid content before droplet impact is mentioned. However, from electrospraying technology it is well known that droplets originating from a Taylor jet are charged at more than half the Rayleigh limit and can only be slightly reduced in diameter before droplet fission sets in, meaning that electrostatic repulsion in the droplet overwhelms the surface tension and the droplet becomes unstable. Droplet fission is always accompanied by subsequent repulsion of the "daughter droplets". A reduction of droplet diameter by more than a factor of ~1.3 during its time in air is therefore always accompanied by a large spread of daughter droplets and is drastically increasing the size of the printed structures. Additionally the increase of the in-air time of liquid portions, in possibly all embodiments, will also require an increase in the nozzle-substrate distance. A higher nozzle-substrate distance will again induce a larger spreading of impacting liquid.

A problem which is present for all droplet ejection techniques and particularly the ones where pipette openings in the range of O (100) nm are used is clogging, which is associated to fluid evaporation at the tip. For small pipettes in the range of O (100) nm also for nonvolatile liquids the evaporation rate at the nozzle can lead to a doubling of the nanoparticle concentration in milliseconds. If waiting times between ejections are increased, this problem gets more serious. The effect is well visible in an electrohydrodynamically printed pattern by Park et al. (Nature Mat., 2007, 782) in an image showing ancient scholar Hypatia, where some droplets appear clearly larger than others. The image was produced by moving the stage during continuous ejection. It is very likely that these large droplets correspond to the points of controlled initiation of a new printing line which is accompanied by a certain delay time between the initiation of the new line and the end of the last line. The higher the frequency of droplet ejection, the less this problem arises. If a 3D structure is produced by ejection of a jet fragment followed by a waiting time of O (0.1) s or even O (1) s, and the repetition of these steps, as stated in US 2006198959, the resulting structures cannot be as small as the minimal droplet size even for nonvolatile solvents. Most likely due to a combination of the mentioned problems, 3D structures printed by electrohydrodynamic jetting having a diameter of less than ~300 nm and with nozzle/structure ratio above ~3 have not yet been reported. Therefore the technological solution in US 2006198959 states the production of structures with a fine diameter made of droplets having an ultra-fine diameter and not the production of ultra fine structures by ultra fine droplets. Furthermore neither dots nor 3D structures were reported to be printed with very high placement accuracies well below 100 nm.

SUMMARY OF THE INVENTION

The present invention therefore relates to and proposes a new electrohydrodynamic (EHD) printing process allowing high precision and at the same time droplet deposition sizes hitherto not possible.

The present invention thus provides measures overcoming these problems by building structures reproducibly and highly efficiently at the size of the ejected droplets which are more than a magnitude smaller than the nozzle opening and wherein essentially no liquid accumulation will occur during the course of liquid ejection but only the growth of three-dimensional structures based on dispersed solid material with essentially the same diameter of one single droplet with diameters down to 50 nm or less and where this structures are grown at extremely high positional accuracy and in a fashion that allows almost freeform 3D structures in one production step and at great possibilities of parallelizing the process. The basic principle of ejecting liquid in any electrohydrodynamic process is the same in that a voltage is applied between electrically connected liquid in a nozzle and a counter electrode leading to the ejection of charged liquid portions. However, dependent on the exact parameters used, liquid can be ejected in fundamentally different ways, e.g. in the form of a continuous liquid jet or by the ejection of one droplet after another. Therefore the considerations that set the mode of ejection are crucial for the possible applications because one mode might be completely inappropriate for a specific application while another mode fulfills all its requirements.

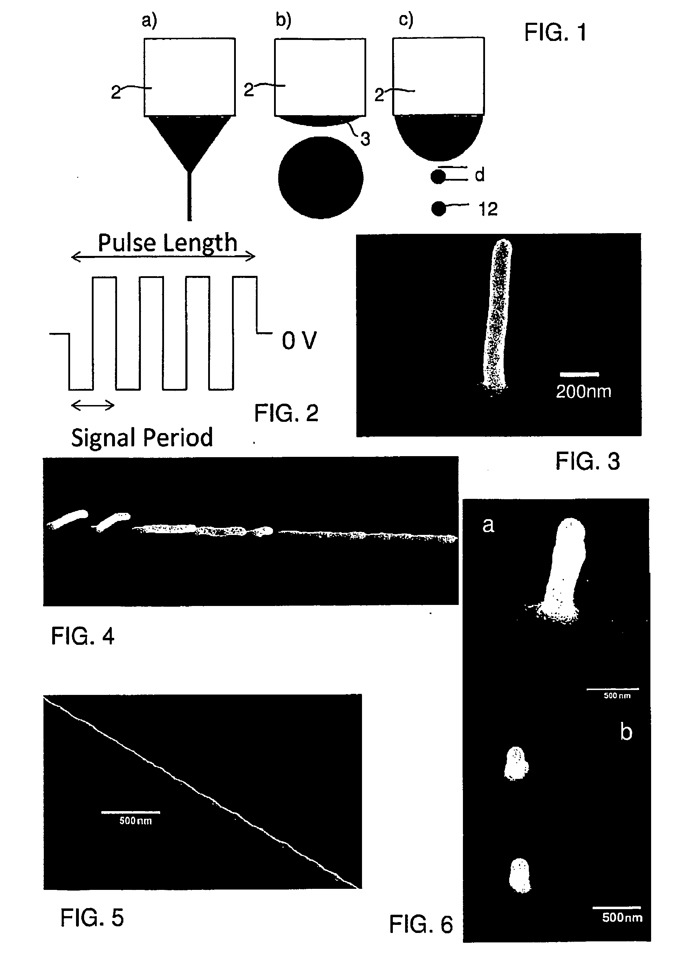

The main modes of interest for the present invention are ejection by dripping, microdripping and cone-jet mode (Figure 1). Especially the cone-jet mode (Figure la) has been of great interest due to the possibility of spinning fibers in so-called electrospinning or producing electrodsprays. The electrospraying process is based on a cone-jet liquid stream that, due to evaporation, reaches the Rayleigh limit leading to the abrupt repulsion of the charged droplets which originate from the instable jet. After ejection from the capillary nozzle the liquid jet or droplet may also undergo various instabilities that create droplets from the jet.

In dripping mode (Figure 1b) a droplet usually larger or equally sized than the nozzle diameter is detached against surface tension by the combined action of gravitational and electrical stresses. In microdripping mode (Figure 1c) droplets much smaller than the nozzle diameter are ejected from a steady meniscus of hemispherical to ellipsoidal appearance at a highly homogenous size and frequency. The quasi-steady meniscus is in contrast to the meniscus in dripping mode that periodically changes size and shape. The quasi-steady nature in microdripping can be attributed to the smaller size of single droplets which are only capable of transporting a fraction of the meniscus volume. The meniscus thus does not experience a significant disruption. This is in stark contrast to the dripping mode. The decrease in droplet size is attributed to increased electrical stresses in the latter case. In general, dripping/microdripping occurs at low liquid flow-rates for fluids of low conductivity. Microdripping is demonstrated to produce monodisperse droplets smaller than the nozzle diameter at frequencies up to 10 kHz. The present invention relates to this microdripping mode but at dimensions not in the micrometer but rather in the nanometer regime. Therefore, the mode of ejection will be called nanodripping in the following.

An ink containing nano-sized solid material, which is left behind after fluid evaporation is used for the deposition process. An extreme precision is achieved in that it is accomplished that at a given moment in time there is only one electrically charged nano-droplet, or rather a nanodroplet, in the space between the tip of the capillary and the surface of deposition. In this manner, charged droplets do not have to bear repulsive forces during their flight which would lead them to be deflected from their optimal trajectories. In comparison to a jetting mechanism, where a continuous jet or a jet fragment is ejected from a nozzle, the present technique allows the liquid volume being transferred to the substrate to be portioned in the form of periodic ejections of single droplets at a highly homogeneous ejection frequency. If the frequency and droplet volume are small enough, droplets will not only be uninterrupted by other flying droplets but the carrier liquid of impacted droplets will additionally have time to be evaporated before a new droplet arrives at the surface. It is therefore not necessary to interrupt the applied voltage in order to allow for evaporation. Instead, the evaporation and ejection are optimized by the intrinsic ejection frequency and the unit of ejection, always being a droplet with "jet-like" diameter. The terminology "jet-like" indicates that we are treating droplets with basically the same diameter as an emerging jet just without being elongated. Hereby at the nozzle a liquid meniscus is created due to the application of an electric field. At minimal threshold electric field intensity a droplet, having essentially the size of the meniscus itself, will be ejected at the nozzle. By only slightly increasing the electric field, the droplets will rapidly decrease in size and become many times smaller in diameter than the meniscus itself. Volume portions, being ejected will only be a diminishing fraction of the total meniscus volume. The meniscus, instead of being destabilized, e.g. retracted or ejected, remains stable, while only at its end "tip", facing the substrate, small droplets will be ejected at constant frequencies. Ejection frequencies of more than 100 kHz are possible and allow for high speed pattern creation without the need of sophisticated electric equipment.

The correspondingly necessary conditions, specifically in particular the flow rate of the liquid through the nozzle and the intensity of the applied potential difference between the nozzle or rather the electrode contacting the liquid in the nozzle and a counter electrode is determined to fit these conditions.

One important condition is that the average rate of ejection of liquid volume per time period is matched by the average evaporation rate of ejected liquid per time period, from essentially the beginning of the ejection process. Here average means that the unsteady evaporation rate is averaged over a time period much larger than the duration between two consecutive droplet ejections in order to achieve a constant value. By matching these rates it is made sure that no liquid will accumulate on the substrate but rather the solid material contained in the liquid droplets will be left behind and can be stacked to a three-dimensional structure.

Another important result of the process structuring is the fact that the droplets have a diameter which can be much smaller than the meniscus diameter with the latter being directly related to the geometrical properties of the nozzle. For example, working with a capillary tip, which can be made of glass and be coated with a metal electrode, the meniscus diameter would basically correspond to the outer diameter of the capillary opening. With an outer diameter in the range of 1000 nm, it is possible to generate droplets with an average diameter in the range of typically below 50 nm. This is a significant advantage due to the positive effect of larger opening on clogging avoidance and the general handling and robustness of the system.

If nozzle and substrate are fixed during ejection, a filament with circular cross section and arbitrary bending can be grown from left-behind solid material, with a diameter essentially equal to the diameter of a single droplet. In the following such filaments will often be called pillars. A pillar does therefore not necessarily relate to a straight filament but can be bent. Since the fluid is essentially removed before another droplet arrives on the surface, the solid material which is contained in the droplet can be stacked without being further spread due to liquid accumulation. At the beginning of the process, droplet impact positions may not perfectly match but rather correspond to a statistical distribution wherein one point will correspond to the position of highest impact density. At this position also the density of solid material, remaining after fluid evaporation, will be largest. Correspondingly at this position a structure will start to grow into the air, towards the nozzle, herein called the z-direction of the coordinate system, where the other two directions perpendicular to the z-direction, are labeled with x and y or simply summarized as the radial (or sometimes also called lateral) direction r. Once this structure starts to emerge, the presence of the structure will locally induce stronger electric field intensity at the same polarity as its environment. This is true for both, metallic as well as dielectric structures with a relative permittivity higher than that of air. The electric field is introduced by the external electric field used for droplet ejection as well as by the charged droplet flying towards the emerging structure. Because the applied electric field attracts a charged droplet towards the substrate and since the intensity is higher in the proximity of the emerging structure, a droplet will, even if its trajectory is not perfectly normal to the substrate, be attracted and therefore directed towards the structure. The attraction effect is strongest for metallic structures as well as dielectric structures with a relative permittivity much larger than 1. Starting from a rather dispersed droplet accumulation at the very substrate surface, the further impact of droplets will lead to structure growth at always the same position with respect to the nozzle-substrate axis and finally the droplet impact position will converge due to the attraction effect of the emerging structure composed of the remaining solid material. The shape of this structure will be pillar-like with a diameter essentially defined by the diameter of a single droplet. In this way structures can be grown not only much smaller than the nozzle diameter but also at extremely high precisions and with sizes down to a few tens of nanometers. The attraction effect of the emerging structure is only local and exponentially decays when moving away from it. The effect is most prominent only at a distance which is equal approximately to the diameter of the structure. Therefore, if structures are attempted which have the same diameter as a single droplet, it is necessary to decrease the spreading of droplets below ~3 times the droplet diameter. This can be achieved by reducing the substrate-nozzle distance to values which are preferably below about 10 times the meniscus diameter.

The applied potential difference can be in the form of a DC voltage with constant or changing amplitude or consist of a voltage of alternating polarity (AC) with constant or changing amplitude. For an applied AC voltage the change in electric polarity leads ejected droplets to have opposite electrical charge so that after one full period of ejection the ejected charge is essentially neutralized. For both forms of applying a voltage a pulse length can be defined, which is the duration of the signal, at least during the time the voltage is above the ejection threshold. For the AC signal additionally an internal frequency, the AC frequency can be defined or likewise the signal period. The relation of these two times is demonstrated in Figure 2.

Only one droplet is in the air at a time and the charge transferred by the droplets is removed due to electrical contacting of the substrate or via the gas phase or by neutralization via AC printing, fast enough not to interfere with the printing process.

The ejected droplets are attracted and stacked at the sharp top of the emerging structure consequently converging the impact spreading of droplets to preferably one fixed position. The diameter of this structure is homogeneous and essentially equal to the diameter of a droplet. An example of such a structure is shown in Figure 3.

The height of the grown structure is, if no other parameters are changed during ejection, directly proportional to the time during which the voltage was applied.

The time at constant voltage, required between initial growth and final height h of a pillar structure with the same diameter as a single droplet, depends on the droplet ejection frequency f, the droplet diameter d and the nano-material volume concentration c:

$$t \approx \frac{3h}{2c \cdot d \cdot f} \qquad (1.2)$$

and the velocity of pillar growth into the z-direction depends on c, d and f:

$$v_s \approx \frac{2c \cdot d \cdot f}{3} \qquad (1.3)$$

The central point of subsequently printed structures with respect to the intersection of pipette axis and substrate are repeatable with a precision better than 10 nm if the requirement is met that pillars grow at the same diameter as a single droplet.

The aspect ratio of printed pillars is typically 25 or lower; the aspect ratio of printed pillars can be between 25 and 50 or higher if the substrate-nozzle distance is increased during pillar growth. A structure with a diameter of ~100 nm and an aspect ratio of ~15 is shown in Figure 3.

The relative substrate-nozzle movement can be realized additionally or solely in the x-y directions and slower than the structure growth velocity. The structure in this case is, additionally to growing into the z-direction, also growing in the x-y-direction and is following the relative movement of the nozzle away from the immediate structure end and where the immediate angle θ at which the structure is growing relative to the x-y-surface is defined by the ratio of the structure growth velocity $V_s$ to the velocity of the relative nozzle-substrate movement $V_{ns}$-

$$\theta = 90° \frac{v_s - v_{ns}}{v_s}, \qquad v_{ns} \leq v_s \qquad (1.4)$$

If the relative velocity of substrate-pipette movement is larger than the structure growth velocity, this causes the structure to not continue growing in the z-direction anymore but instead to continuously grow only parallel to the substrate along the movement of the pipette relative to the immediate structure end finally produceing a line of constant height if the velocity is constant and to a line of varying height if the velocity is varied. Accordingly by moving the substrate and/or the nozzle during droplet ejection almost freeform lines for $V_{ns} > V_s$ or freeform pillars for $V_{ns} < V_s$ can be created. Of special interest is the case of $V_{ns} \approx V_s$, which results in a floating pillar, being parallel to the substrate but not necessarily in contact with the underlying substrate. The transformation from a tilted pillar to a horizontal floating line and finally to a line contacted to the substrate is illustrated by Figure 4, in which $V_{ns}$ was increased during the course of ejection. The combination of these structure growing schemes can lead to almost arbitrary shapes in three dimensions.

The trajectory at which a line is created can be repeated for several times, so to speak overprinting the previous line with a second line and so forth until a wall is created with a height corresponding to the height of a single line times the amount of lines that have been printed onto each other. A line printed with several consecutive cycles, a width of ~45 nm and almost constant height is shown in Figure 5. Based on the SEM image the height is estimated at ~100 nm. For lines that are printed by consecutive cycles the vaporization of the solvent has not necessarily to be advanced to a high percentage before impact of the next droplet. If the line speed (velocity of substrate movement by the stage) is fast enough only few droplets will impact at the same position during one cycle and liquid accumulation can therefore be inhibited. A requirement is however, that the droplet has completely evaporated until the nozzle arrives to the same position in its next cycle. The requirements for printing lines of the same diameter as a single droplet are therefore less rigorous than for pillars. However, as already mentioned this is only true if the line speed is fast enough, so if $V_{ns} >> V_s$, otherwise lines cannot be as wide as the diameter of a droplet. The succeeding line can be printed along the preceding line with a constant positional offset in x-y-direction perpendicular to the trajectory of the followed line, which if successively repeated with increasing offsets, leads to a tilted wall.

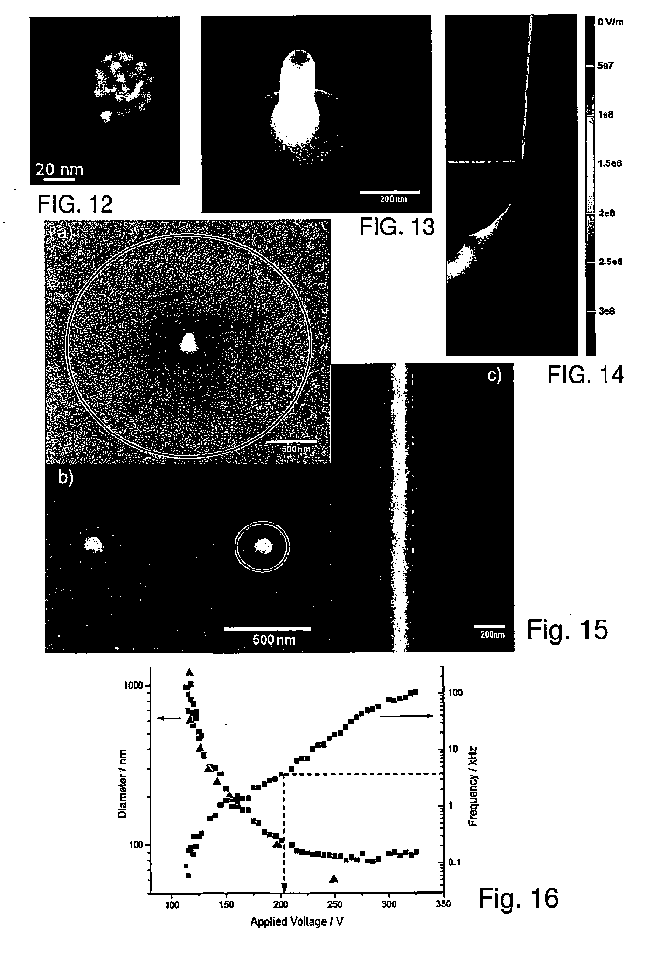

Since the attracting effect of growing structures onto approaching droplets is fulfilled for both metals and dielectric materials with relative permittivity higher than one, pillars or other structures can be grown at the same size as a droplet for a host of materials. While all the other structures shown in this disclosure are based on gold, Figure 16 a and b shows pillars made of zinc oxide and silver, respectively.

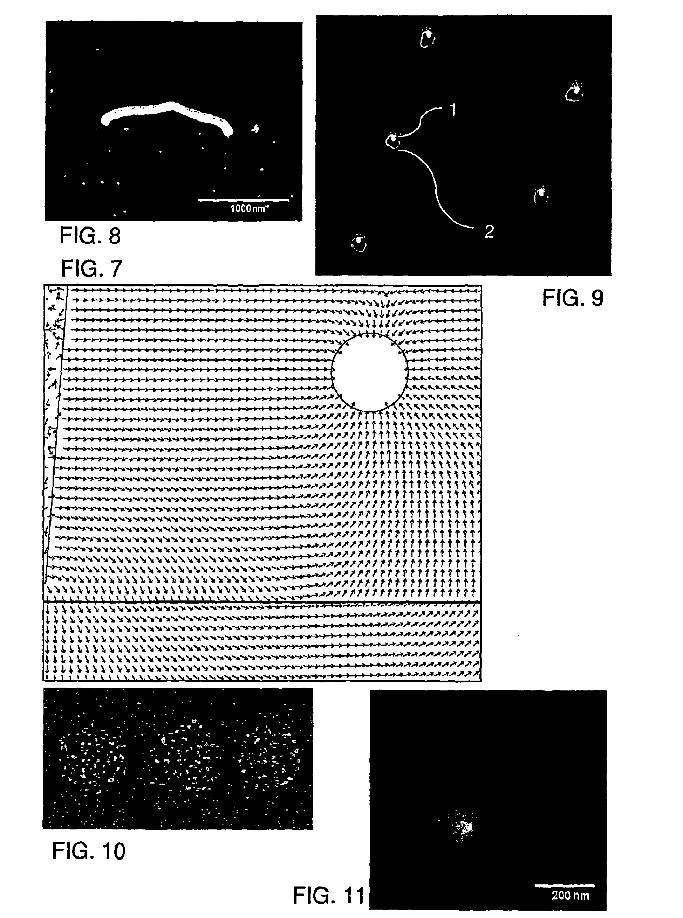

The counter electrode can be positioned in or/and on and/or below and/or above the substrate. If the counter electrode is above the substrate, due to the small distances required between nozzle and substrate it is sometimes difficult to position the counter electrode between the nozzle and substrate. Therefore the present invention also relates to an embodiment where the counter electrode is positioned above the nozzle. It is not intuitive that droplets can still be attracted to the substrate even if they are thereby flying away from the oppositely charged counter electrode. However, if the electric field is modeled for such a system it is apparent that droplets are still attracted to the substrate even if they are thereby moving away from the counter-electrode. Figure 7 shows the orientation of the electric field around a capillary pipette where the counter electrode has been positioned above the nozzle in the form of a ring electrode. The substrate has been modeled as a glass slide and the interface between the air and the substrate is highlighted with a horizontal solid line. While electric field lines are obviously pointing from one electrode to the other, the electric field just below the nozzle is pointing towards the substrate with the radial component being zero along the nozzle-substrate axis, almost equal to the situation in which the counter electrode would be associated with the substrate. The same result with respect to the orientation and approximately the intensity of the electric field between nozzle and substrate is achieved if the substrate is modeled as a floating potential, i.e. a metal layer which is not electrically connected and uncharged. The configuration has not necessarily to be a ring electrode. Here a flat electrode design is chosen in which a hole 16 with a diameter of $\sim$300 $\mu$m, but at least two times larger than the nozzle diameter and preferably smaller than 1000 times the nozzle diameter, is drilled into a flat PEEK plate 14. Subsequently the PEEK plate is inserted into a physical vapor deposition device and coated on one side by first 10 nm of Titanium followed by 100 nm of gold. The coated metal electrode 15 is now connected via a voltage supply 10 to the nozzle electrode 7,8,9. The plate is fixed by a commercial mechanical stage to end up on top of the substrate 1 and leveled parallel to it and the capillary pipette 2, i.e. the nozzle 3, can then be moved through the hole while observing from below by a microscope objective. If an electrical potential U above the ejection threshold is applied by the voltage source 10 between nozzle electrode 7,8,9 and counter electrode 15 droplets 13 will be ejected from the nozzle 3 and accelerated towards the substrate 1.

A way to achieve connections of subsequently printed structures which can also be done with different material is the connection by image charge creation and attraction. If two structures are printed in a distance from each other which is lower than 2 times the pillar height, preferably lower than 1.5 times the pillar height they can be connected solely by the fact that the second pillar contains some accumulated ionic charge left after the deposition process while the first pillar is essentially charge-free but due to the acting of the charge of the second pillar an image charge will be induced at the first pillar which leads the pillars to be attracted to each other and eventually snap together if this force is strong enough. Since the charge-to-mass ratio of small droplets is higher than it is for large droplets, the force can be increased by increasing the ejection voltage which increases the charge-to-mass ratio. From the Rayleigh limit calculation we know that the charge decreases with the power of 1.5 of the droplet diameter, while the resistance to bending of a pillar decreases with the power of 4 of its diameter (which is equal the droplet diameter) and with the power of 2 if the height is increased. If pillars are to be bent, either the height has to be increased, the diameter reduced or the accumulated charge increased. The last can be increased by decreasing droplet size (higher charge-to-volume ratio) or by increasing the flow rate for a given diameter. A further possibility of increasing the attractive forces is by placing the structures closer to each other, but higher than $\sim$2 diameters to assure formation of a second pillar. Decreasing the mechanical resistance to bending is straightforward and is simply achieved by reducing the droplet diameter (e.g. by increasing the voltage or reducing the nozzle size) or by increasing the ejection duration which leads the pillars to grow taller. Figure 8 shows the image of a structure produced in this way.

We have also compared the present technique to an interrupted ejection mechanism, similar to a jetting based ejection scheme which necessitates a pause between subsequent high volume flow rate ejections. By waiting for only about 250 ms between subsequent ejections the nanoparticle concentration at the very nozzle region ($\sim$1 $\mu$m diameter) can increase by several times due to evaporating solvent, leaving behind an ink with higher nanoparticle concentration even for a very nonvolatile solvent like tetradecane. Here we applied a short voltage pulse in order to eject droplets, followed by a short waiting time of zero voltage and subsequently another ejection at the same voltage as before, wherein this procedure was repeated for several times, and by which a structure is grown. However, growing structures do not adopt diameters given by the droplet diameter but are indeed much larger. This resembles the problem that first droplets are different than subsequent droplets, in nanoparticle concentration but most probably also in size, even if the waiting time between subsequent ejections is in the range of O (10) ms. Creating a pillar structure by the present technique and then, after a waiting time of O (100) ms, printing with the same pipette at the same position leads the first structure to be splashed by the impact of the second ejection. In Fig. 9 structures are shown from above where probably the second (2) structure is intact while the first structure (1) is left as a thick splash of nanomaterial. This is most probably due to the higher mass and therefore kinetic energy of the first droplets and/or due to the increased fluid volume arriving on top of the existent structure, mainly at the beginning, if droplets are larger. Therefore the present methods are not based on the common way of on-demand printing where droplets are ejected by user-induced ejection and waiting cycles. Rather the present method makes use of the fact that droplets are ejected at a natural and highly homogenous frequency which can be larger than 100 kHz. Only one stimulus at the beginning of the process is needed in order to build the meniscus and start the ejections, i.e. changing the voltage between meniscus and counter electrode to a value which is higher than the ejection threshold, wherein the voltage before the stimulus was either zero or below the ejection threshold voltage. If the initial voltage is only slightly below the ejection threshold a meniscus will already be (partially) built. An advantage of a previously built meniscus is that the geometry which defines the intensity of the electric field at the liquid surface and therefore also the electrical stress, is already set at the beginning and first droplets will not necessarily be much larger than following droplets. Once the voltage has changed to a new value above the ejection threshold by the first stimulus, droplets will be ejected at highly homogenous frequencies until a second stimulus ends the ejection. This stimulus is the change of the applied voltage to a value below the ejection threshold. Here it has to be clarified that even if AC voltages are used the ejection is not interrupted in the common sense. Charge carriers on the liquid meniscus surface will change polarity but the meniscus will be quasi-steady. The duration between the first and the second stimulus is here also called the pulse length of the applied voltage. Due the highly homogenous nature in droplet size, pillars can be grown very homogenously and the base region is well defined and of essentially the same diameter as the rest of the pillar, especially for inks of low concentration (here low concentration is used to describe low volume fractions of the dispersed species) and for substrates that are wetted well by the droplets. It cannot be circumvented that a printed structure is surrounded by a thin layer of printed material, which represents the first larger and more concentrated droplets as well as the initial spread of droplets around the region of highest impact density. In most cases this spreading area is between 2 and 3 times the droplet diameter which illustrates again the need for the spreading area to be lower than about 3 times the droplet diameter so all droplets are in the influence regime of the emerging structure. By reducing the ink concentration, this region is reduced in thickness to a very thin layer. If for example the dispersed species are nanoparticles this layer can be reduced to the thickness of one layer of nanoparticles wherein for the largest fraction of the spread area the nanoparticles are not in physical contact as long as the footprint of a single droplet, i.e. the nanoparticles that are left on the substrate after liquid evaporation, results in a layer of nanoparticles which are not covering the whole footprint area (see Figure 10). If the concentration is considerably higher each impacting droplet leaves behind a a fully covered layer or even a layer with a thickness that can be several times thicker than one monolayer, where the monolayer thickness is defined as the diameter of an average sized nanoparticle. This is the reason why lower concentrations result in better defined base regions, as was stated above. The diameter of the nanoparticle spread around a printed structure, consisting of many impacted droplets, can be reduced by reducing the nozzle-substrate distance. The nozzle-substrate distance should preferably be larger than 2 times the meniscus diameter in order to avoid contact between meniscus and substrate. By increasing the nozzle-substrate distance to a value which is too high, structures start to grow larger than the droplet diameter. Figure 11 shows the example of a structure that is growing at a distance of ~10 $\mu$m while the meniscus diameter was assumed to be ~600 nm. While the structure has a diameter of ~200 nm, footprint data suggests droplet diameters of about 80 nm. This exemplifies the relation between meniscus diameter and nozzle-substrate distance which states that the distance should be smaller than ~10 times the meniscus diameter in order to achieve pillar diameters equal the droplet diameter.

A last form of droplet deposition by relative movement of nozzle and substrate is the deposition of single, highly homogenously sized droplets but separated from each other. The relative movement of substrate and nozzle has to be higher than the intrinsic line velocity which is defined by the diameter of a droplet times the ejection frequency. If the velocity is double the intrinsic velocity single droplets will be deposited with a gap between each other which on average is equal to one drop diameter. This is possible due to the high homogeneity of the droplet ejection frequency.

In general, if the liquid wets the substrate well, the contact angle of the liquid on the substrate will be small, the contact line will likely get pinned and nanoparticles might get stuck on the substrate leading to a spread of remaining material on the area of impact which can be seen in Fig. 10 where three droplets were impacted next to each other and nanoparticles are spread over the impact region. If the substrate surface energy is reduced by depositing self-assembled monolayers of 1H,1H,2H,2H-Perflurooctyltrichlorosilane from the vapor phase, the contact angle between substrate and droplet is increased and the interaction of nanoparticles with the substrate will likely be weaker leading the particles to not be attracted and get stuck at the substrate anymore but be able to freely move in the solvent during droplet evaporation. If the contact line retracts during evaporation, which is commonly observed for contact angles in the range of 90°, and at the same time the nanoparticles are mobile, the dispersed material will be moved by the retracting contact line until a densely packed circle of nanoparticles results. This monolayer has a reduced diameter compared to the area which is covered by the nanoparticle footprints of droplet impacting on substrates where the contact angle is low. In order to achieve a monolayer of nanoparticles, the nanoparticle concentration c should be chosen such that it fulfills the following conditions.

$$c \leq \frac{m}{8d}, n << d$$

Here n is the nanoparticle diameter and d is the droplet diameter. If this formula is not fulfilled additionally the contact line may not retract during evaporation even for substrates which are not wetted well by the solvent. If the formula is fulfilled, in general homogenous monolayer depositions can be obtained, tightly packed for the case that nanoparticles are retracting with the solvent contact line. Figure 12 shows the remaining nanoparticles of a droplet impacted onto a functionalized surface where the nanoparticles have retracted with the solvent to build a tight packed monolayer. In the case of printed pillars the substrates to be printed on are preferably substrates on which the used solvents have a very low equilibrium contact angle, preferably < 20°. On such a substrate the impacting droplets will similarly wet both the substrate as well as the emerging structure. Additionally, the better the solvent wets the surface the higher the evaporation rate. If the substrate is not wetted by the droplet the base might be slightly thicker than on wetted substrates due to initially smaller evaporation rates and the fact that nanoparticles do not strongly interact with the substrate and might therefore still be mobile, e.g. if the solvent retracts during evaporation. As soon as the pillar starts to emerge the growth mechanism is not dependent on the substrate anymore and takes place in the same way on every substrate as long as the geometry of the printing system and the electric vector field are the same. An example of a pillar with a diameter of ~110 nm grown on a nonwetting substrate is shown in Figure 13. The base is clearly thicker than a monolayer.

The present invention relates to different kinds of printable structures. It relates to single footprints based on only one droplet, to printed lines, pillars and dots. The width of a line, as well as the diameter of a pillar and a dot, is the characteristic size of the structure. A line is defined as the limit of a lying pillar. It has a width which is preferably equal to the diameter of a single droplet and is, already during the printing process, in physical contact to an underlying substrate and follows its topography. The substrate is regarded as the top surface layer of the framework it is printed on. Therefore it can also be thought of as a previous layer that was printed onto an underlying surface layer. In contrast to a line, a pillar has a clear region of initiation where it is connected to the underlying substrate. For the rest of its extent it is not in physical contact to the substrate, but is growing into the z-direction with any constant or changing angle between 0 and 90° with respect to the lateral movement direction and the z-direction. At least during the actual growth process it can therefore not grow away from the nozzle but always grows towards it. It can be negatively sloped, i.e. be bent away from the nozzle, or be in contact (but not be directly attached) to the substrate if the structure relaxes downwards after printing, e.g. due to electrostatic or gravitational action. A printed structure can also consist of parts of both, pillars and lines. A dot is equal to a pillar for which the aspect ratio (length/diameter) is ≤ 1. Accordingly a pillar has an aspect ratio ≥ 1.

The regions of pillars, lines and dots where they are attached to the substrate are surrounded by one or several layers of nanoparticles building a basis around printed structures, at least on substrates which are wetted well by the solvent. A line is surrounded by such a basis along its whole extent. The basis has a thickness that is always smaller or even much smaller than the actual structure height which it surrounds, i.e. a printed line, pillar or dot. Most preferably the basis has a thickness equal to the diameter of a single nanoparticle. If structures are growing with the same diameter as a single droplet and the evaporation between consecutive droplet ejections is therefore fast enough, reducing the thickness can be achieved mainly by reducing the volume concentration of nanoparticles in the liquid or by the use of a substrate which is wetted well by the liquid, preferably with an equilibrium contact angle < 20°. The diameter of the basis surrounding a pillar or dot is generally larger than the basis which is found parallel to a line. This is due to the fact that for pillars the first droplet problem is encountered which stands for the different size and volume concentration of first droplets ejected from the nozzle after a waiting time, and wherein the waiting time is the time between finishing a structure and starting with the ejection of new droplets for the creation of a new structure or any other time duration during which no liquid was ejected before the start of a new ejection cycle. Increasing this time does also lead to an increase of the size of the basis. Therefore if the waiting time between subsequent droplet ejections is decreased, also the size of the basis is decreased. The extent of the basis can grow several times larger than the characteristic size of the structure if waiting times are in the range of generally O (1) s or larger as is illustrated in Figure 15a for a nozzle size in the range of 1 μm and nonvolatile tetradecane being the solvent. In order to decrease the extent of the first droplet effect such that the basis is smaller than 4 times the characteristic structure size, waiting times have to be reduced to O (100) ms, preferably to O (10) ms or smaller. Figure 15b shows small pillars for which the basis is ~3 times as large as the characteristic structure size. With ~150 ms the waiting time was still chosen relatively high but the basis is strongly decreased compared to the structure shown in Figure 15a. The actual extent of the basis due to droplets ejected subsequently to the first 2-5 droplets is below 3 times the characteristic size of the structure, preferably smaller than 2 times the characteristic size of the structure but always larger than the characteristic structure size. These values are directly based on the requirement that the spreading area has to be smaller than ~3 times the droplet size and can accordingly be reduced by reducing the nozzle-substrate distance.

A line is only influenced by the first droplet effect at the point of its initiation. A line does therefore often have a larger basis at its beginning while the rest of the line is not influenced by the first droplet effect and the basis is therefore always similarly large, preferably smaller than 2 times its characteristic size. Figure 15c shows a line which has a basis about 2 times larger than the characteristic size of the structure.

It is shown in the following that the mode of droplet ejection is based on certain parametric requirements. The ejection of droplets more than a magnitude smaller than the diameter of the pipette is achieved by an electrohydrodynamic ejection mechanism which is related to the microdripping mode, but at much smaller scales than previously reported. In order to cope with this dimensional down-sizing this mode will be termed "nanodripping". Accessing the nanodripping regime is typically based on the requirement that the characteristic time for the supply of liquid is much longer than the characteristic time of jet, respectively drop formation. The time for supply of liquid is based on the flow rate and defines the time it takes to replace a liquid portion of characteristic dimension at a given flow rate.

$$\tau_q = \frac{\pi d^3}{6Q} \qquad\qquad (1.5)$$

Where d stands for the characteristic size of the system (here the droplet diameter) and Q for the measured flow rate. The characteristic time of drop formation is based on the intrinsic properties of the fluid.

$$\tau_d \approx \frac{\mu d}{\gamma} \qquad\qquad (1.6)$$

Here $\mu$ is the liquid viscosity and $\gamma$ is the liquid surface tension.

The meniscus is formed under the influence of electric field intensity while at higher electric fields additionally a smaller droplet at the meniscus apex is created. This small droplet is ejected at some point whereas the meniscus stays steady. In order to allow such a steady meniscus the charge relaxation time, i.e. the time it takes for the liquid ions to adjust to an electrical stimulus, has to be much lower than the supply of liquid to the meniscus. Otherwise the removal of surface-relaxed ions by convection could not be compensated by bulk conduction. The supply of liquid can be characterized by above formula 1.10 but with d being exchanged with the meniscus diameter D. The charge relaxation time is defined in the following way.

$$\tau_0 = \frac{\varepsilon}{\sigma} \qquad\qquad (1.7)$$

Where $\varepsilon$ is the relative permittivity of the liquid and $\sigma$ is its conductivity. Here it should be mentioned that unlike in cone-jet mode, the charge relaxation time does not necessarily have to be smaller than the supply of liquid to the small droplet. In order to numerically derive the size of droplets ejected at a certain voltage, the total force acting on the droplet has to be balanced. As long as no pressure is applied above or below the liquid, for the treated dimensions these forces can be limited to the induced electrical force and the opposing surface tension. The electrical force is represented by the Maxwell Stress Tensor applied at the surface of the small droplet and acting into the z-direction. The observed time between droplet ejections is, up to relatively high voltages, not lower than the charge relaxation time and we can therefore assume that the surface of the small droplet is at equipotential with the meniscus surface. For high voltages, i.e. if the time between ejections is shorter than the charge relaxation time, this assumption will not deliver accurate results anymore. The electrically relaxed surface leads field lines to be normal to the surface and the electrical force takes a simple integral form represented by the right side of the following equation. The left side represents the surface tension acting onto the small hemisphere.

$$d\pi\gamma = \iint \frac{1}{2} |\mathbf{D}(d, V)| \cdot |\mathbf{E}(d, V)| \cdot da_z \qquad\qquad (1.8)$$

Here d is the diameter of the small hemisphere, E and D are the electric and displacement fields and $da_z$ is the differential representing integration over the hemisphere surface in z direction. While the force resulting from the left side of the equation is readily derived for a specified d, the right side (for the specified geometry) is computed. By varying the input voltage the electrical force can now be matched to the surface tension force. For the diameter of the meniscus the outer diameter of the pipette opening can be used. The modeled geometry and the resulting intensity of the z-component of the electric field are shown in Figure 14. Results of the simulations show a strong decrease in droplet diameter as soon as the voltage is slightly higher than the minimal ejection voltage. This is illustrated in Figure 16 (triangles).

In order to confirm the numerical results, experiments were performed that were targeted at deriving droplet diameter, ejection frequency and flow rate. For droplets with diameters of ~100 nm travelling at more than 100 m/s, photodetection (e.g. laser Doppler or stroboscopic measurements), the common technique used for droplet characterization, is not a feasible tool. Verifying the concept of nanodripping ejection and confirming the numerical results has therefore relied on an indirect detection method. The pipette was fixed in space while the underlying substrate was moved by a piezostage at defined velocities up to $10^{-2}$ m/s. In this way subsequent droplets were separated and their footprints, consisting of nanoparticles left behind (Figure 10), could be analyzed. By assuming the droplet diameter to be equal the footprint size the experimental results correspond well to the results of the simulations (Figure 16, black squares). That footprints are essentially representing the droplet diameter is confirmed by the correspondence of the simulations to the experiments for the whole regime of droplet sizes. If a large amount of spreading would occur, the absolute deviations between observed and calculated diameters should be larger for large droplets which is clearly not the case. Furthermore also the printed pillars have the same diameters as the footprints even if in the former case droplets do not impact onto the substrate itself but only onto a sponge of nanoparticles. Also the largest observed droplet diameters are equal to the capillary diameter which is thought to be equal to the meniscus diameter. Since the electric force is the only external stimulus and since gravitation is irrelevant, the meniscus will not grow larger than the capillary diameter and therefore droplets do not acquire sizes larger than the nozzle size.

The frequency can be derived by analyzing the same footprint patterns. The known velocity at which the piezostage is moving is simply divided by the distance between droplets which are found subsequently in a line. The frequency data is plotted in Figure 16 as squares forming a line from bottom left to top right. As mentioned above, high ejection frequencies lead the equipotential assumption to be not valid anymore. The charge relaxation frequency ($1/\tau_e$) is ~4 kHz. The voltage at which the ejection frequency matches with this value is indicated with an arrow in Figure 16. As expected, for higher voltages, i.e. ejection frequencies higher than the charge relaxation frequency, experimental and calculated data do not match anymore which is reproduced by the divergence of the datasets in Figure 16.

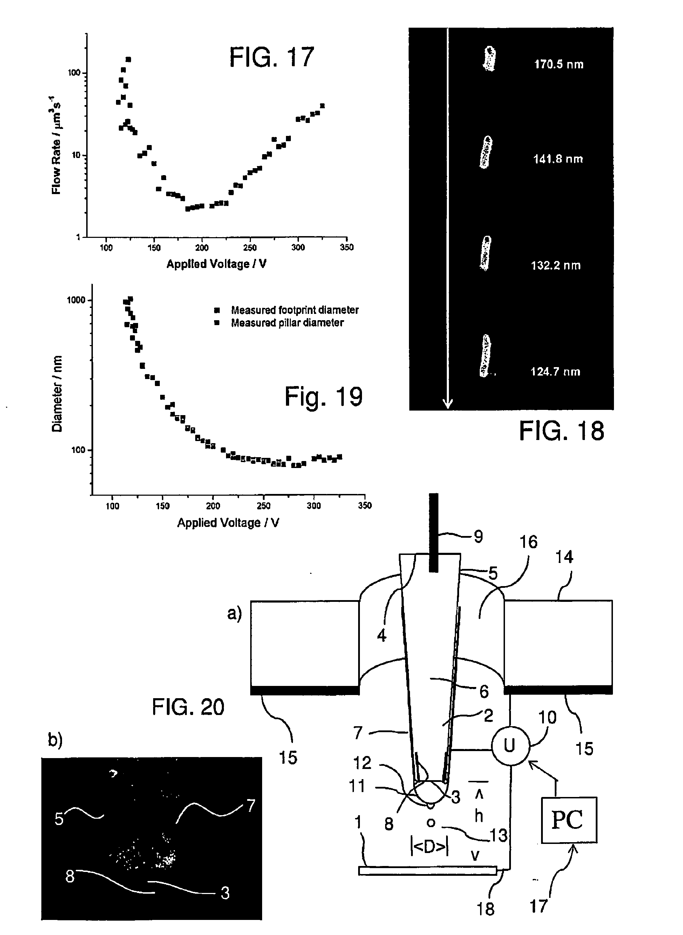

With the information about droplet ejection frequency and droplet diameter also the flow rate can be directly derived by calculating the volume of a droplet and multiplying it with the droplet ejection frequency (Figure 17). For low voltages where the droplet diameter strongly decreases with increasing voltage also the flow rate decreases. For higher voltages the droplet diameter is almost converged while the frequency still increases and therefore also the flow rate increases. The flow rate is mainly determined by the diameter of the meniscus, the liquid viscosity, the surface tension and the applied electrical potential and pressure. The easiest and most effective way of reducing the flow rate is by reducing the diameter of the meniscus, e.g. by decreasing the nozzle diameter. Additionally the flow rate can be reduced by increasing the viscosity of the fluid or the surface tension. The flow rate can also be influenced by a change in voltage as clearly reproduced in Figure 17. A useful way of changing the flow rate is by applying a pressure difference above and below the liquid situated at the nozzle. If the pressure above the liquid is lower than below the liquid/nozzle the flow rate will be increased. Pressures in the range of O (0.1) to O (1) bar are most useful. The other way around it will be decreased and can also be used in order to reach the nanodripping mode for the case the flow rate is too large for a certain set geometry and liquid.

In Fig. 18 a row of nanorods is presented which have been printed at different voltages but at the same pulse length. The image illustrates the crucial concept that the structure width follows the droplets diameter which is decreasing for higher voltages. The approximate diameters emerge in the following order for higher voltages: ~170 nm, 142 nm, 132 nm and 125 nm fitting exactly with the observed footprint diameter. Figure 19 shows measured droplet diameters and additionally includes, for the same system, pillar diameters for a set of voltages. At high voltages (for this specific system above ~275 V) homogenous pillars could not be grown anymore, most probably due to the high flow rates which cannot be matched by the evaporation between consecutive droplet impacts anymore.

More specifically, the present invention relates to a method for the production of 1D, 2D and/or 3D depositions from a nano-particle loaded liquid by means of a capillary for holding the liquid with an outer diameter D and a tip opening having a diameter of at least 50 nm, wherein there is provided an electrode in contact with said liquid in said capillary, and wherein there is a counter electrode in and/or on and/or below and/or above a substrate, preferably also above the nozzle, onto which the depositions are to be produced. The process includes the steps of:

i) keeping the electrode and the counter electrode on an essentially equal potential or at a potential difference below the minimal voltage at which a droplet is ejected (ejection threshold voltage);

ii) establishing a potential difference between the electrode and the counter electrode leading to the ejection of nano-droplets at frequencies exceeding 100 kHz;

iii) while the potential difference is still applied, droplets are impacting at the surface and are largely evaporated in a timeframe before the next droplet arrives.

iv) while the potential difference is still applied, the repetition of impact, evaporation, impact etc. leads a 3D structure to be generated in a continuous process without the requirement of turning off the applied voltage.

Herein the distance between the substrate and the tip opening is smaller than or equal to 20 times the meniscus diameter at least at the moment of nano-droplet ejection. The conductivity and dielectric constant of the liquid is chosen such that the requirement of charge relaxation time being lower than liquid supply to the meniscus is fulfilled. Due to the extremely short residence time of droplets in air they will always fly alone without the presence of other droplets which could possibly disturb their trajectories. In order to allow stacking of material at continuous liquid ejection, at the moment of impingement of a subsequent nano-droplet at the place of deposition the solvent of the preceding nano-droplet has essentially to be completely evaporated or at least to a degree at which the deposited material is stabilized and fixed in position at least at the time a structure starts to emerge. It is tolerable if the condition above is not fulfilled for first impacting droplets as long as it is fulfilled if a structure starts to emerge, i.e. as soon as a particle basis has been built and accordingly as soon as the substrate surface has no influence on the impact and evaporation behaviour anymore. This mainly relates to substrates that are not wetted well by the liquid leading to a decreased evaporation rate as already outlined above.

According to a preferred embodiment of the method a statistical accumulation of contained material in the droplets on the substrate is given by the impact area and position of all impacted droplets, wherein at the position of highest impact density a nano-sized structure will start to continuously grow into the z direction, wherein preferably droplets are attracted to the emerging structure due to increased electric field density at the nano-sized structure, and wherein preferably the increased electric field density at the emerging structure is induced by an external electric field, preferably the one used for droplet ejection, the electric field of the charged droplets themselves or both of them; wherein the emerging structure is of the form of a dot or a pillar for the case that nozzle and substrate positions are fixed relative to each other and wherein a dot is defined as a pillar with aspect ratio equal or smaller than 1 and wherein the z-direction is its major axis; and wherein the height of the dot or pillar is proportional to the time during which the electrical voltage was applied;

According to a preferred embodiment of the method the width of printed lines and the diameter of printed dots or pillars, have essentially the same size as the diameter of a single ejected droplet;

If the ejection flow rate cannot be reduced to an amount that matches droplet evaporation between consecutive impacts, another liquid with higher vapour pressure can be used as a solvent. However, in this case also the evaporation at the meniscus will increase and therefore also the risk of clogging especially for small pipettes. Therefore, for small pipettes preferably nonvolatile solvents with low vapour pressures are used while for large pipettes, solvents with higher vapour pressures are used. For nozzle sizes smaller than $\sim 2\ \mu m$ the vapour pressure of the solvent is preferably in the range of 0.0001-0.01 kPa, most preferably in the range of 0.0005-0.005. For nozzle sizes of $\sim 20\ \mu m$ the preferable range of vapour pressures would accordingly be in the range of 0.1-10 kPa, most preferably in the range of 0.5-5 kPa. These values are based on a diffusion coefficient which is equal to that of tetradecane. If the diffusion coefficient of a liquid is larger than that of tetradecane, the optimal vapour pressure would be smaller by about the same fraction as the increase in the diffusion coefficient. Also, the background pressure of the gaseous form of the liquid has been assumed to be equal to that of tetradecane at normal atmospheric conditions. For all liquids it has additionally to be taken care that the liquid evaporation at the meniscus, during liquid ejection, is smaller than the liquid ejection flow rate. Otherwise, the nanoparticle concentration at the meniscus continuously increases which leads to inhomogeneous deposits or even to full clogging of the pipette. Reducing the evaporation at the meniscus can or should be achieved by cooling the nozzle. Additionally the temperature at the sample can be increased in order to allow for faster evaporation of impacted droplets. The difference in temperature can be increased until the induced convection of air due to temperature differences does not start to influence the droplet trajectories. Also the heat transfer from nozzle or substrate to the air or contrariwise should not be larger than the heat transfer from the heating and/or cooling source to substrate or nozzle, respectively. As soon as one part is heated or cooled, both parts are affected and should fulfil the above criteria, the substrate as well as the nozzle. If for example only the substrate is heated, also the temperature of the nozzle might increase. In this case the heat transported from substrate to nozzle via the air is not removed fast enough by the heat sink connected to the nozzle, which in this case would likely be the surrounding room temperature. With an increase of the meniscus temperature also the evaporation rate at the meniscus is increased and therefore the risk of clogging.

The viscosity of the ink is preferably chosen to be in the range of $\mu = 0.4\ 10^{-3}$ - 1.5 Pas, preferably in the range of $10^{-3} - 10^{-2}$ Pas, in each case at the temperature of running the deposition process, and wherein further preferably its surface tension is in the range of $\gamma = 0.001\text{-}0.0073$ N/m.

Preferably, the diameter of the tip opening is at least twice as large as the diameter of the nano-droplets.

Particularly preferably it is in the range of 200-1000 nm, most preferably in the range of 400-800 nm.

The nozzle is preferentially in the form of the small opening of a pulled glass capillary which is coated at the outside wall and at some small portion at the inside of the small opening with a layer of conductive material, most preferably with a noble metal like gold or platinum. The coated part at the inside of the small opening is preferably extending into the pipette not further than half of the inner pipette opening, most preferably extending at an amount smaller than a fourth of the inner diameter of the pipette opening. The meniscus size of such a coated capillary is essentially equal to the outer diameter of the small pipette opening. For ejection also an array of nozzles can be used which can be actuated at the same time and illustrates the scalability of the invention.

The concentration of the solid material contained in the liquid is lower than 10 Vol.-%, preferably at 0.01-1 Vol.-%, most preferably in the range of 0.05-0.25 Vol.-%.

The solvent is preferentially selected such that the above-mentioned evaporation conditions can be fulfilled and the viscosity fits the purpose, preferably it is selected from the group of water, organic solvent, or mixture thereof, preferably selected from the group of saturated or unsaturated or partially saturated carbohydrate solvents, aliphatic alcoholic solvents, water, and mixtures thereof.

The solid material being dispersed in the liquid are preferentially stably dispersed nanoparticles of any composition of metal or metal oxide, semiconducting or other inorganic material, e.g. ceramic and/or magnetic nanoparticles. The dispersed solid material can also be made of carbon-based conductive material, like carbon nanotubes, fullerenes or graphene, of biological material like enzymes, DNA, RNA, of other dispersed/dissolved (macro) molecules which are not prone to vaporization, e.g. conductive or nonconductive polymeric substances.

During the process additionally a lateral relative nozzle-substrate movement can be applied for a controlled lateral displacement of the nano-droplets deposition on the surface with respect to previously printed structures or the relative nozzle-substrate movement during ejection is in z-direction away from the substrate in order to allow the growth of taller pillars, wherein the electric field can be adjusted to the movement of the stage to compensate for decreasing electric field intensity at the meniscus due to the higher nozzle-substrate distance. The decrease in electric field intensity is inversely proportional to the distance between nozzle and substrate, also for the case that the counter electrode is fixed above the nozzle and does not move relative to the nozzle during ejection, at least if the substrate has a higher dielectric constant as the surrounding air or if it is metallic. Furthermore the present invention relates to correspondingly made structures such as nano-pillars, and it for example also relates to the making of optical nano-antennae or plasmonic devices

Further embodiments of the invention are laid down in the dependent claims.


BRIEF DESCRIPTION OF THE DRAWINGS

Preferred embodiments of the invention are described in the following with reference to the drawings, which are for the purpose of illustrating the present preferred embodiments of the invention and not for the purpose of limiting the same. In the drawings,

Fig. 1    shows the modes of electrohydrodynamic liquid ejection which are of most interest for the present invention, namely dripping (b), microdripping (c) and cone-jet mode (a);

Fig. 2    shows a schematic of the used AC voltage pulse. The pulse length does herein define the amount of ejected droplets while the signal period defines the alteration frequency at which polarity of ejected charged droplets changes;

Fig. 3    shows a printed pillar with a homogenous diameter of ~100 nm from base to top and an aspect ratio of -15;

Fig. 4    shows the transformation from a tilted pillar at slow nozzle-substrate movement up to the limit of a line at higher velocities by continuously increasing $V_{ns}$ during ejection;

Fig. 5    shows a printed straight line which is imaged by SEM at a tilting of 30° and allows to see that the line is expanding into the z-direction. The width of the line is at ~45 nm and the height at ~100 nm;

Fig. 6    shown in a) a printed zinc oxide nanopillar and in b) two printed silver pillars both based on dispersed nanoparticles of the same material;

Fig. 7    shows an illustration of the orientation of the electric field around a pipette, where a potential difference was applied between the pipette wall (including the meniscus) and a ring-like counter electrode situated above the nozzle;

Fig. 8     shows two pillars that have been printed in a consecutive manner and have merged due to the electrostatic interaction being stronger than mechanical resistance towards bending;

Fig. 9     shows structures, imaged from top, which have been printed with two subsequent voltage pulses and brief pause of O (100) ms in between in order to mimic printing by intermittent structure growth. Unlike the way of droplet stacking during one pulse, the first structure (1) seems to be splashed by the impact of the first droplets of the second structure (2);

Fig. 10    shows droplet footprints, i.e. the area in which nanoparticles can be found after impact and evaporation of single nanodroplets;

Fig. 11    shows a structure that was printed onto a glass substrate with a capillary nozzle at a distance larger than 10 time the meniscus diameter when preferably the distance should be smaller than 10 times the meniscus diameter. Accordingly the structure does not attain the diameter of a single droplet. The structure diameter is about 2.5 times larger than the droplet size;

Fig. 12    shows the remaining nanoparticles of a single droplet impacted onto a self-assembled monolayer of fluorinated alkyl chains. The functional layer increases the contact angle of the sessile droplets and leads the nanoparticles to retract with the liquid resulting in a smaller footprint essentially being a monolayer of close-packed nanoparticles;

Fig. 13    shows pillars printed onto a surface functionalized in the same way as in Figure 12. The higher contact angle and the different evaporation behavior on these surfaces leads to thicker and more compact base regions, while the growth of the actual pillar is independent of the substrate;

Fig. 14    shows the intensity of the electric field in z-direction for the case that the counter electrode is situated below a glass substrate. The frame indicates the boundary of the capillary nozzle while the meniscus is modeled as a hemisphere with the same diameter as the nozzle and where the pendant droplet is modeled as a smaller hemisphere attached to the lower part of the meniscus;

Fig. 15    shows a comparison of the base regions of structures printed onto a glass substrate wherein the approximate extent of the base region is enclosed by black lines or circles for a) a pillar printed after a no-ejection time of -2s, b) a pillar for which the no-ejection time was ~150 ms and c) and a continuously printed line;

Fig. 16    shows the frequency and diameter behavior of ejected droplets. Black squares represent the measured footprint diameter while the squares forming a line from bottom left to to right represent the frequency based on footprint separation. Calculated values for the droplet diameter are illustrated by triangles. The voltage at which the frequency approximately matches the charge relaxation frequency $1/\tau_e$ is illustrated with a dashed arrow;

Fig. 17    shows the flow rate behavior with respect to the applied voltage. The flow rate is based on the experimental droplet diameter and ejection frequency;

Fig. 18    shows four pillars that were printed at increasing voltages of 165, 170, 175 and 180 V (following the white arrow) at the conditions introduced in the experimental section. The diameter of the pillars decreases according to the droplet-voltage behavior shown in Figure 15;

Fig. 19    shows the experimentally observed footprints (black squares) and additionally the diameters of printed pillars for a set of voltages (grey squares);

Fig. 20    shows in a) the general setup for the experiments, and in b) a SEM image of the coated pipette tip;

Fig. 21    shows an array of nanodots printed at a lateral distance of 1 $\mu$m from each other. Additionally the applied voltage is increased from the bottom to the top line. While the diameter for the lowest dots is in the range of 130 nm, the dots in the top row have diameter in the range of 100 nm;

Fig. 22    shows two lines printed with a pitch size of 100 nm. The width of the lines is in the range of 60 nm;

Fig. 23    schematically shows the chosen arrangement for performing scattering spectroscopy and dark field mode imaging of printed nanostructures;

Fig. 24    shows a dark-field image of a printed nano-pillar wherein the electric field of incoming light was oriented along the structure's main axis. The donut shape of the image is proof for the dipolar nature of the radiation source, here being the nano-pillar;

Fig. 25    shows scattering spectroscopy graphs of a printed nanopillar, which has a diameter of ~53 nm and an aspect ratio of ~6 (inset). Incoming light polarization along the pillar axis (longitudinal) and perpendicular to it (in-plane) result in almost the same resonance pattern; and

Fig. 26    shows scattering spectroscopy graphs of a printed and annealed nanopillar with a diameter of ~53 nm and an aspect ratio of ~6 (a) and a second pillar with a diameter of ~45 nm and an aspect ratio of ~12 (b). The insets show SEM images of the respective pillars.

DESCRIPTION OF PREFERRED EMBODIMENTS

The section illustrates the proposed printing of 3D submicron structures. In the setup a gold-coated nozzle is filled with and in electrical contact to an ink. An electrical potential is applied between the nozzle and a counter electrode in and/or on and/or below and/or above a substrate to be printed on. Applying a high enough electrical potential between nozzle and counter electrode results in a regular ejection of monodisperse droplets. The nature and scaling relations of these droplets are considered in this work. Experiments demonstrate that the frequency strongly increases with the applied potential. The droplet diameter strongly decreases and converges to a final value once the charge relaxation time is longer than the time of liquid supply to the small droplet. For the used test system varying the applied potential between 100V and 400V increases the droplet frequency from 60 Hz to 100 kHz while the droplet diameter decreased from 1 micron to less than 100 nm. The mode of printing is similar to microdripping but at much smaller scales, therefore called nanodripping. This nano dripping mode allows producing monodisperse droplets smaller than 100 nm at frequencies exceeding 100 kHz.

Experimental section:

The setup consists of a gold-coated glass capillary with a small opening having an inner diameter of ~800 nm and an outer diameter of ~1200 nm achieved by a commercially available pipette puller, which is filled with a commercial suspension of in average 5 nm sterically stabilized gold nanoparticles in tetradecane purchased from ULVAC Technologies. The volume concentration was at ~0.1 Vol% while the small capillary opening was positioned at ~4 $\mu$m away from a ~0.15 mm thick glass substrate. For the mentioned diluted ink an electrical conductivity of ~6.5·$10^{-8}$ S/m was measured. The glass substrate was placed onto an ITO-coated microscope glass slide without fixing it. The ITO-coating was used as the counter-electrode but allowed optical access from below by a confocal-type optical microscope which allows in situ detection of single printed structures down to ~20 nm as long as they are separated from each other by more than ~450 nm.

Using a piezostage this substrate can be moved relative to the stationary nozzle of the capillary. A function generator allows the application of arbitrary voltage pulses which are amplified to O(100) V. The frequency, diameter and flow rate data presented hence was obtained for a single nm nozzle while other images show structures being printed at variations of these parameters.

Figure 20a shows schematically the set up for the experiments. A capillary 2 is located above a surface 1 onto which deposition shall take place. In the capillary 2 there is located a liquid loaded with solid nano-sized material, here called ink 6. The capillary is formed by an essentially circular converging glass wall 5, which has a tip opening 3 with an outer diameter D and a back side opening 4. The inside of the capillary 2 is essentially filled with the above-mentioned ink 6.

In the tip portion the capillary wall 5 is coated on its surface on the outer side with an electrode coating, i.e., a metal coating, which is schematically indicated with 7. This electrode coating is not only present on the outside of the capillary, where it is also used for contacting the wiring to the voltage source 10 which is controlled by control unit 17, but it extends around the terminal edge forming the tip opening 3 and partly penetrates into the inside and covers, at least in the very tip portion, also the inside surface of the wall 5. Therefore it comprises an inside portion 8, and contacts the liquid in the capillary. The electrical contact to the liquid can also be achieved by immersing an electrode 9 into the liquid.

In a micrograph such a tip is shown in figure 20b, and shows that the surface of this electrode coating 7 forms a rather rough surface structure. Therefore care has to be taken that no clogging of the tip opening 3 can take place in this region partly realized by reducing the penetration depth of the coating into the tip. After applying with a voltage supply 10 an electrical potential U between the electrode in contact with the liquid (7 and 8 or 9) and a counter electrode 18, which can be any metallic layer in and/or on and/or below the substrate 1, a liquid meniscus 11 starts to build at the tip opening 3. According to the voltage-diameter behaviour which follows the general trend shown in Figure 16 and 19, a small droplet 12 will evolve and finally be ejected into the air. The counter electrode does not have to be associated with the substrate to be printed on 1 but can also be above the substrate. This counter electrode can be a plate 14 situated parallel above the substrate 1 and having a hole 16 through which the capillary 2 can be guided through and which additionally is coated with a metallic layer 15 on the side facing the substrate 1, wherein application of an electrical potential above the ejection threshold between this metallic layer 15 and the capillary electrode (7 and 8, or 9) by a voltage supply 10 results in ejection of droplets 13. Therefore into a plate of PEEK or another insulating material 14 with a thickness of ~1 mm a hole 16 of ~300 μm or at least twice as large as the nozzle, but preferably not larger than 1000 times the nozzle diameter, is drilled, through which the capillary pipette 2 is passed. The hole 17 can also have a larger diameter on the side which is not facing the substrate in order to allow access to thicker parts of the capillary 2. Onto the side of the PEEK plate, which will face towards the substrate 1 a metal electrode 15 is coated by physical vapour deposition of 10 nm of Titanium and 100 nm of Gold, which is contacted to a voltage supply 10 being controlled by a control unit 17. If an electrode 15 above the substrate is chosen, no electrode 18 has to be associated with the substrate 1 but the substrate 1 is preferably an uncharged floating conductor or an insulator. The plate can be positioned at any distance above the substrate 1 but is preferably located at a distance between 50 and 500 μm.

This work determines both the droplet frequency (Figure 16, squares forming a curved line from top left to bottom right) and droplet diameter (Figure 16, squares forming a curved line from bottom left to top right) from the droplet footprints of single droplets ejected during the application of a DC pulse between 100 V and 400 V at the experimental conditions described above. Given that direct time-resolved observation is nearly impossible at these length scales this indirect option is chosen instead of direct visualization. For this experiment, the piezo-stage is moved at constant speeds up to 10 mm/s while a DC voltage is applied between electrode and counter-electrode. The result of this experiment is a line of footprints like those shown in Figure 10 that may be analyzed in an SEM. The frequency of droplet impact is obtained by dividing the speed of the stage by the center-to-center droplet distance. The flow rate at a certain voltage can then be simply deduced by multiplying the droplet volume by the ejection frequency resulting at a certain voltage applied (Figure 17).

Data Analysis of footprint experiment: Frequency Data: One finds that the frequency ranges from 60 Hz to more than 100 kHz and increases with the voltage.

Landing Footprint Data: The footprint diameter decreases from more than one micron to less than 100 nm. Droplets therefore clearly become smaller with increasing voltages while for high voltages the droplet diameter converges to a final value or might even slightly increase again. The convergence of droplet size is thought to be connected to the ejection frequency being faster than the charge relaxation frequency which leads the droplet to not acquire the full charge given by certain electric field intensity because ions are not able to fully relax on the liquid surface. The droplet size is reproduced by the results from numerical analysis of the electric field for the geometry shown in Figure 14 and solving for equation 1.8. The results match with the observed droplet footprints. Only at higher voltages the datasets start to diverge which is, as mentioned above, due to the increasing droplet frequency which is higher than the time necessary to relax charge at the surface of the small pendant droplet 12. The frequency at which the charge relaxation time is equal the ejection frequency is indicated with an arrow in Figure 16. This is exactly the point when the datasets start to diverge.

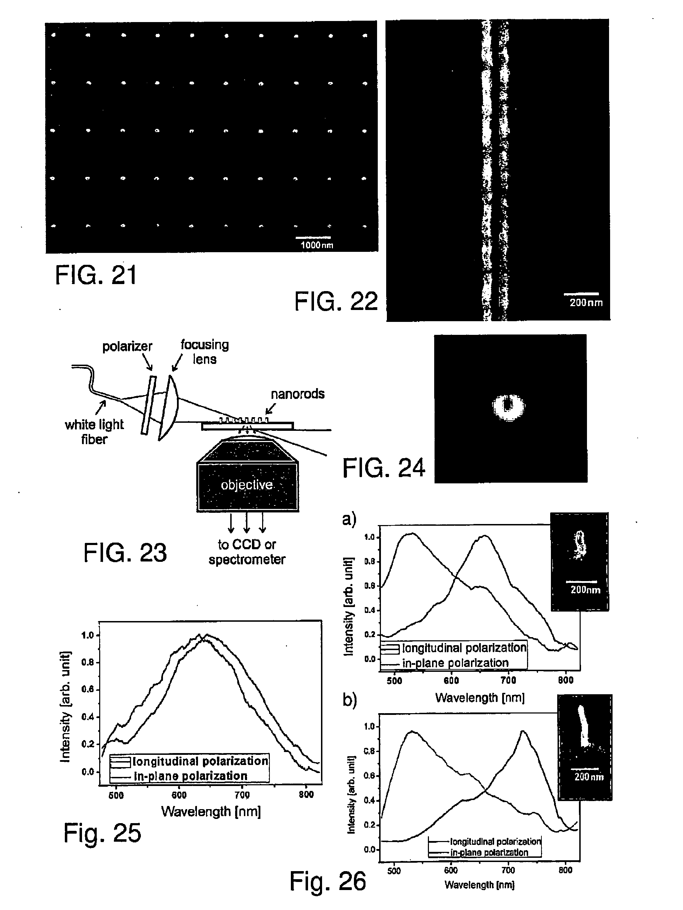

The extraordinarily high positional accuracy of the presented method is illustrated with an array of printed nanodots for which a distance from each other of 1 micrometer was attempted (Figure 21). The structure almost exactly resembles this programmed distance, with deviations from the attempted position which is probably in the range of the inaccuracy of the used piezostage, i.e. around 5 nm. Structures at the top row have a slightly smaller diameter which stems from a slight increase of voltage from bottom to top rows.

The high positional accuracy can also be illustrated with printed nanolines. In Figure 22 we present two printed nanolines which exhibit a pitch size of only 100 nm with the lines having a width of ~60 nm.

Nanopillars made of noble metals have recently found some unique applications as optical nanoantennas in the context of light-matter interaction. The remarkable control on the material, position, and dimensions of the nanopillars achieved by our method promises inexpensive production of such nanoantennas. Focusing and controlling light at scales below the diffraction limit is based on the formation of the so-called plasmon resonances, which are a result of collective oscillation of electrons all along the metallic nanostructures. The dimensions of the nanopillars produced by the present invention (diameter < 100 nm) are of particular interest, because they allow interaction with light at a specific resonance frequency defined by a dipolar oscillation mode with higher modes being largely absent. In order to compare pillars made of close packed nanoparticles, with nanopillars made of bulk gold we need to remove the sterical stabilization coating and sinter the particles. For this purpose, we anneal the printed gold nanopillars by heating them to 200 °C with a quick ramp of 10 °C/s followed by a slower ramp of 3 °C/s to 260 °C and then an immediate cooling. Annealing can also be performed in an oxidizing environment facilitating the removal of carbon residues, e.g. by introducing ozone. Annealing, furthermore, increases the electrical conductivity of the printed pillars. We investigate the optical properties of the structures by measuring their scattering spectra. The measurement is done in dark-field configuration, which is schematically depicted in figure 23. White light from a xenon lamp is brought to the setup through a fiber. The beam hits the sample at an angle almost tangential to the sample surface. An air objective (Olympus, 60X,NA 0.8) is placed under the sample. Due to the small grazing angle of the excitation beam, it does not couple to the objective. However, the scattered light from the pillars is collected by the objective and is either sent to a CCD camera for imaging the particles or to a spectrometer to take their scattering spectra. A pinhole with adjustable size in the detection path allows us to select only the scattered light from a single pillar. A polarizer rotated by a stepper motor is placed in front of the fiber in order to control the excitation polarization. To excite different resonances of a pillar we either choose a polarization along the long axis of the pillar (longitudinal polarization), or perpendicular to it (in-plane polarization). A CCD image of a nanopillar excited with longitudinal polarization is shown in figure 24. The symmetric doughnut shape of the image is a fingerprint of a strong dipolar emission perpendicular to the sample surface. The typical spectra from a single pillar for the two polarizations before annealing the sample are shown in figure 25. Although the longitudinal spectrum has a slightly red-shifted resonance, the amount of this shift is not as large as expected and the spectra are rather broad revealing losses inside the pillars. The spectra for two pillars with diameters of ~53 nm and ~45 nm and aspect ratios of ~6 and ~12 are shown in Figures 26 a and b, respectively. The SEM pictures of the pillars taken after tilting the sample by 30 degrees are also shown as insets. Here, as compared to the case before annealing (Figure 25), we observe a larger separation between the two resonances, which is in line with previous observations, as well as a substantial narrowing of the spectra. Furthermore, the longitudinal resonance of the longer pillar is red-shifted as compared to that of the shorter pillar. Where the radiated light of an optical nanoantenna is of interest, which is most often the case, a narrow, less lossy spectrum is preferable, as for the case of printed annealed nano-pillars or dots. However, there are applications where it can be of benefit to achieve higher nonradiative energy dissipation, i.e. broader spectra, for example for heating purposes (e.g. thermosolar energy) or if energetically excited electrons can be consumed at an adjacent interface, e.g. at a metal-semiconductor interface (Schottky barrier). Therefore the present invention does not only allow generating specific resonance frequencies by varying the pillar height but it also allows, to a certain degree, defining the ratio of radiative to nonradiative energy dissipation by choosing over annealing or no annealing.

Such antennas could also be used for bundling, directing and polarization of light, as an optical tweezer, for sensors, for the integration into photovoltaics or even as an energy harvester by directly collecting the current oscillation in the pillars which are induced by the incoming light. Furthermore they could be of use in nonlinear optics or in optical waveguides.

LIST OF REFERENCE SIGNS

1    surface/substrate

2    pipette/capillary

3    tip opening of 2

4    backside opening of 2

5    wall of 2

6    ink filled into 2

7    electrode on 5

8    part of 7 being inside of 2

9    electrode immersed into 6

10    voltage source

11    liquid meniscus

12    droplet evolving at 11

13    droplet after being ejected from 11

14     flat plat of PEEK

15     electrode on 14

16     small hole in 14 and surrounded by 15

17     control unit giving input to 10

18     conductive element/layer associated with 1 making contact to a voltage supply 10

h     distance between 1 and 3

D     diameter of 11

d     diameter of 13

c     volume concentration of solid species in 6

f     ejection frequency of 13

$V_s$     pillar growth velocity

$V_{ns}$     relative substrate-nozzle movement velocity

by changing the output of 16

$\sigma$     electrical conductivity of 6

$\varepsilon$     relative permittivity of 6

$\varepsilon_0$     permittivity of air

U     voltage supplied by 10 against electrical ground

$\gamma$     suface tension of 6

$\rho_l$     density of 6

n     nanoparticle diameter

v     velocity of 13 towards 1

E     electric field vector

D     electric displacement vector

$\mu$     viscosity of 6

Q     liquid ejection flow rate

**Claims**

1. Method for the production of 1D, 2D and/or 3D solid depositions from a nano-material loaded liquid (6), by means of a liquid reservoir (2) for holding the ink with a nozzle (3) having an opening diameter of at least 50 nm, and larger than 300 nm, wherein there is provided an electrode in contact with said ink (6) in (9) or at (7,8) said liquid reservoir (2), and wherein there is a counter electrode in and/or on and/or below and/or above a substrate onto which the depositions are to be produced, including the steps of:

i) keeping the electrode (7,8,9) and the counter electrode (15,18) on an essentially equal potential or at a potential difference below the minimal voltage necessary for droplet ejection;

ii) establishing a variable potential difference between the electrode (7,8,9) and the counter electrode (15,18) which leads to a periodic ejection of single charged droplets (13) with a diameter smaller than the meniscus diameter and their acceleration by the electric field to the substrate (1);

periodically repeating the steps i) and ii) until the deposition is generated, wherein the distance between the substrate (1) and the nozzle (3) or between a structure situated on the substrate and the nozzle (3) is smaller than or equal to 200 μm at least at the moment of droplet ejection (12);

wherein droplets (13) are generated with an average diameter in the range of 10-1000 nm and are ejected at a frequency in the range of 10Hz to 100 kHz, and wherein at a given moment in time there is no more than one droplet (13) in the trajectory between the tip opening (3) and the surface (1) and such that at the moment of impingement of a subsequent droplet (13) at the place of deposition the solvent of the preceding droplet (13) has essentially evaporated or at least evaporated to such an extent that the contained nano-material is fixed in position at least at the moment droplets do not impact directly onto the substrate anymore but onto a solid basis of deposited material that has accumulated on the substrate.

2. Method according to claim 1, wherein the droplet diameter is decreased by increasing the applied electrical voltage and wherein preferably the frequency is increased by an increase of the applied electrical voltage;

3. Method according to any of the preceding claims, wherein the distance between the substrate (1) and the nozzle (3) or between a structure situated on the substrate and the nozzle (3) is smaller than or equal to 20 μm, preferably smaller than 10 μm, at least at the moment of droplet ejection (12).

4. Method according to any of the preceding claims, wherein the step ii) involves establishing a potential difference between the electrode (7,8,9) and the counter electrode (15,18) leading to the formation of an electric field with essentially no radial component along the nozzle-substrate axis and which leads to the growth of a stable meniscus (11) at the nozzle (3) and to the periodic ejection of single charged droplets (13) with a diameter smaller than the meniscus diameter and their acceleration by the electric field to the substrate (1).

5. Method according to any of the preceding claims, wherein substrate and nozzle positions are moving during droplet ejection at a constant or dynamic velocity relative to each other wherein the relative substrate-nozzle movement velocity is in z-direction and is matched to the structure-growth velocity in order to allow higher aspect ratios, and/or wherein further preferably the voltage is adjusted to the reduction in distance in order to keep the electric field at the meniscus constant, where the electric field at the meniscus is proportional to the applied voltage but inversely proportional to the distance between the meniscus and the substrate;

6. Method according to any of the preceding claims, wherein a relative substrate-nozzle movement is carried out in the lateral direction, constant or variable, leading to the growth of tilted pillars, with constant or variable bending, if the velocity is smaller than the structure-growth velocity and leading to a printed line with constant or varying height if the velocity is larger than the structure-growth velocity and leading to growth of a floating horizontal pillar if the velocity is matched to the structure growth velocity.

7. Method according to any of the preceding claims, wherein the distance between nozzle and substrate and/or between the nozzle and a underlying printed or growing structure is smaller than or equal 20 times the ink meniscus diameter, preferably smaller or equal 10 times the meniscus diameter, most preferably 5 times the meniscus diameter but not below one time the meniscus diameter, at least at the moment of droplet ejection.

8. Method according to claim 1, wherein within step ii) a potential difference above the minimal voltage between the electrode (7,8,9) and the counter electrode (15, 18) is established leading to the growth of a stable liquid meniscus (11) toward the substrate at the nozzle at which homogenously sized droplets (13) with a diameter smaller than the meniscus diameter are successively ejected at a frequency which can be actively influenced by changing the voltage, wherein increasing voltages leads to an increasing frequency and smaller droplet size (13);

and wherein within a third step iii) the potential difference is kept above the threshold value, preferably constant, while the fluid flow rate, defined as the volume of liquid ejected per time period is, essentially from the beginning of the printing process, equal to the average evaporation flow rate, defined as the volume of ejected liquid converted into gas form per time period, such that the liquid part of the droplets impacting at the substrate surface is evaporated to an extent to which the formerly dispersed nano-material is completely dry or at least dried to an extent to which the nano-material is fixed in position, before the impact of the next droplet,

and wherein within a fourth step iv) the potential difference is kept above the threshold value, preferably constantly, while the dried or almost dried nano-material that has accumulated on the substrate leads to the growth of a macrostructure wherein the distance between the substrate (1) and the tip opening (3) is smaller than or equal 20 times the liquid meniscus diameter, preferably smaller or equal 10 times the meniscus diameter, most preferably smaller or equal 5 times the meniscus diameter but not below one time the meniscus diameter, at least at the moment of droplet ejection (10).

9. Method according to any of the preceding claims, wherein the electric field used for droplet ejection has a z-component between nozzle and substrate, which accelerates charged droplets towards the substrate, and which is axially-symmetric with respect to the nozzle-substrate axis, such that ejected droplets are essentially following the nozzle-substrate axis.

10. Method according to any of the preceding claims, wherein the applied potential difference is in the form of a DC voltage, preferably a pulsed signal with constant or varying amplitude or an AC voltage with a frequency which is preferably lower than the charge relaxation frequency, being the inverse of the charge relaxation time, wherein preferably the periodic function is preferably in the form of a rectangular signal with the same amplitude in plus and minus and wherein further preferably the droplets created during a positive potential interval are charged at the same amount but oppositely to the droplets created during a negative potential interval, leading to the immediate neutralization of charge on the substrate after one whole period of negative and positive ejection.

11. Method according to any of the preceding claims, wherein the ejection frequency of droplets is between 50 Hz and 100 kHz, preferably between 1 and 20 kHz, and/or wherein the diameter of ejected droplets is between 20 and 200 nm, preferably between 20 and 100 nm, most preferably between 20 and 50 nm, and/or wherein the volume concentration of the dispersed species in the liquid is lower than 10 Vol.-%, preferably in the range of 0.01-1 Vol.-%, wherein most preferably the concentration of the nanoparticles in the liquid is in the range of 0.05-0.25 Vol.-%, and/or wherein the conductivity of the ink (6) is larger than or equal to $10^{-12}$ S/m, preferably between $10^{-8}$ S/m and $10^{-4}$ S/m.

12. Method according to any of the preceding claims, wherein the flow rate, being equal to droplet volume times ejection frequency, is increased or decreased by applying a positive or negative pressure above the liquid reservoir, respectively, relative to the pressure below the meniscus, and/or wherein the flow rate is reduced or increased by increasing or decreasing the fluid viscosity, respectively, and/or wherein the flow rate is affected by a change in voltage.

13. Method according to any of the preceding claims, wherein the liquid reservoir is a capillary having a small and a large opening and where the small opening is used as the nozzle, and/or wherein the electrode (7) is given by a coating on the outer surface of the wall (5) of the capillary (2), which is preferably made of glass, and wherein the electrode (7) at least partially covers the edge of the tip opening (3) and penetrates into the interior of the capillary (2) in the inside portion (8) of the nozzle (3).

14. Method according to any of the preceding claims, wherein the solvent is selected from the group of water, organic solvent, or mixture thereof, preferably selected from the group of saturated carbohydrate solvents, aliphatic alcoholic solvents, water, and mixtures thereof, and further preferably contains at least one of the species selected from the group of preferably nanoparticles which are metal based nanoparticles, most preferably gold-nanoparticles but can also be any kind of metal oxide, semiconducting or other inorganic solid and/or magnetic nanoparticles, conductive carbon-based material, e.g. fullerenes, carbon-nanotubes or graphene, biological material like enzymes, DNA or RNA, or other macro (molecules) which are not prone to vaporization, e.g. conducting or nonconducting polymers for the stabilized dispersion in a liquid solvent and wherein the size of dispersed species in all three dimensions is smaller than 100 nm, preferably smaller than 25 nm, most preferably smaller than 10 nm.

15. 1D, 2D and/or 3D solid depositions from a nano-material loaded liquid (6) made using a method according to any of the preceding claims.

FIG. 1

FIG. 2

FIG. 3

FIG. 4

FIG. 5

FIG. 6

FIG. 8

FIG. 7

FIG. 9

FIG. 10

FIG. 11

FIG. 12

FIG. 13

FIG. 14

Fig. 15

Fig. 16

FIG. 17

FIG. 18

Fig. 19

FIG. 20

FIG. 21

FIG. 22

FIG. 23

FIG. 24

Fig. 25

Fig. 26

Europäisches
Patentamt

European
Patent Office

Office européen
des brevets

**EUROPEAN SEARCH REPORT**

Application Number

EP 11 00 5191

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2010/028712 A1 (ETH ZUERICH [CH]; SCHIRMER NIKLAS [CH]; POULIKAKOS DIMOS [CH]; SCHWAMB) 18 March 2010 (2010-03-18) * abstract * * page 2, line 18 - page 14, line 24 * * page 5, line 5 - page 25, line 16 * * claims 1,21 * * figures 1,2b * | 1-15 | INV. B81C99/00 |
| X,D  A | EP 1 477 230 A1 (NAT INST OF ADVANCED IND SCIEN [JP]) 17 November 2004 (2004-11-17) * abstract * * page 7, paragraph 30 - page 10, paragraph 39 * * page 14, paragraph 61 - page 17, paragraph 103 * * page 19, paragraph 119 * * figures 9,10,17-20 * | 15  1-14 | |
| A | VALASKOVIC G A ET AL: "Automated orthogonal control system for electrospray ionization", JOURNAL OF THE AMERICAN SOCIETY FOR MASS SPECTROMETRY, ELSEVIER SCIENCE INC, US, vol. 15, no. 8, 1 August 2004 (2004-08-01) , pages 1201-1215, XP004523219, ISSN: 1044-0305, DOI: 10.1016/J.JASMS.2004.04.033 * abstract * * page 1205, right-hand column, paragraph 4 * | 1-15 | TECHNICAL FIELDS SEARCHED (IPC)  B81B B81C |

-/--

The present search report has been drawn up for all claims

| Place of search | Date of completion of the search | Examiner |
|---|---|---|
| Berlin | 15 November 2011 | Ekoué, Adamah |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

Europäisches
Patentamt

European
Patent Office

Office européen
des brevets

# EUROPEAN SEARCH REPORT

Application Number

EP 11 00 5191

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | JAWOREK ET AL: "Electrospraying route to nanotechnology: An overview", JOURNAL OF ELECTROSTATICS, ELSEVIER SCIENCE PUBLISHERS B.V. AMSTERDAM, NL, vol. 66, no. 3-4, 28 January 2008 (2008-01-28), pages 197-219, XP022510125, ISSN: 0304-3886, DOI: 10.1016/J.ELSTAT.2007.10.001 * abstract * * page 199, right-hand column, paragraph 5 * * page 205, left-hand column, paragraph 3 - page 205, right-hand column, paragraph 2 * * figure 3 * | 1-15 | |
| A | STACHEWICZ U ET AL: "Single event electrospraying of water", JOURNAL OF AEROSOL SCIENCE, PERGAMON, vol. 41, no. 10, 1 October 2010 (2010-10-01), pages 963-973, XP027406858, ISSN: 0021-8502 [retrieved on 2010-06-30] * abstract * * page 968, paragraph 1 * * figure 1 * * table 1 * | 1-15 | |
| A | CHEN C-H ET AL: "Scaling laws for pulsed electrohydrodynamic drop formation", APPLIED PHYSICS LETTERS, AIP, AMERICAN INSTITUTE OF PHYSICS, MELVILLE, NY, US, vol. 89, no. 12, 20 September 2006 (2006-09-20), pages 124103-124103, XP012085934, ISSN: 0003-6951, DOI: 10.1063/1.2356891 * the whole document * | 1-15 | TECHNICAL FIELDS SEARCHED (IPC) |

The present search report has been drawn up for all claims

| Place of search | Date of completion of the search | Examiner |
|---|---|---|
| Berlin | 15 November 2011 | Ekoué, Adamah |

EPO FORM 1503 03.82 (P04C01)

## ANNEX TO THE EUROPEAN SEARCH REPORT
## ON EUROPEAN PATENT APPLICATION NO.

EP 11 00 5191

This annex lists the patent family members relating to the patent documents cited in the above-mentioned European search report.
The members are as contained in the European Patent Office EDP file on
The European Patent Office is in no way liable for these particulars which are merely given for the purpose of information.

15-11-2011

| Patent document cited in search report | Publication date | Patent family member(s) | Publication date |
|---|---|---|---|
| WO 2010028712 A1 | 18-03-2010 | NONE | |
| EP 1477230 A1 | 17-11-2004 | AU 2003211392 A1 | 09-09-2003 |
| | | CN 1635933 A | 06-07-2005 |
| | | EP 1477230 A1 | 17-11-2004 |
| | | JP 3975272 B2 | 12-09-2007 |
| | | JP 2004165587 A | 10-06-2004 |
| | | TW I224029 B | 21-11-2004 |
| | | US 2005116069 A1 | 02-06-2005 |
| | | WO 03070381 A1 | 28-08-2003 |

EPO FORM P0459

For more details about this annex : see Official Journal of the European Patent Office, No. 12/82

**EP 2 540 661 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1477230 A

- US 2006198959 A

**Non-patent literature cited in the description**

- **PARK et al.** *Nature Mat.,* 2007, 782